# EUROPEAN PATENT APPLICATION

(11) **EP 1 955 780 A1**
(43) Date of publication of application: **13.08.2008**
(21) Application number: 07002290.0
(22) Date of filing: 02.02.2007
(51) Int. Cl.: B05D 1/00, B05D 7/04

(54) **A method of producing a film of carbon nanotubes on a substrate**

(71) Applicant: SONY DEUTSCHLAND GMBH, 10785 Berlin (DE)
(72) Inventor: Ford, William E. Stuttgart Technology Center, 70327 Stuttgart (DE); Jurina Wessels Stuttgart Technology Center, 70327 Stuttgart (DE); Akio Yasuda Stuttgart Technology Center, 70327 Stuttgart (DE)
(74) Representative: Appelt, Christian W.

(57) **Abstract**

The present invention relates to a method of producing a film of carbon nanotubes on a substrate, to a film produced by such method, and to uses of such film.

## Description

The present invention relates to a method of producing a film of carbon nanotubes on a substrate, to a film produced by such method, and to uses of such film.

Carbon nanotubes (CNTs) have emerged as materials of fundamental importance and great potential due to their exceptional electrical, mechanical, and thermal properties. Various proposals exist for their incorporation into devices based on thin nanotube film architectures and geometries. The room-temperature deposition of CNT thin films on any substrate, particularly a plastic substrate, has the potential for realization of cheap, flexible, and transparent electronics. Depending on the density of nanotubes within the film, thin films of CNTs can provide the conducting and/or semiconducting components of passive (e.g., transparent conductive coatings or electrodes) and active (e.g., transistors) electronic devices. For such applications the preparation of homogeneous nanotube films is of paramount importance.

However, the deposition of a homogeneous thin film of nanotubes from solution or suspension is not easily accomplished. Strong tube-tube attractive forces and low solubility impede the use of typical wet chemistry techniques to make uniform films. Furthermore, when nanotubes are suspended or dissolved in solution at low concentrations, evaporation (e.g., drying) of the carrier liquid may result in flocculation and clumping when the local concentration of nanotubes approaches the solubility limit. Moreover, surfactants that may be used to make the nanotubes compatible with aqueous dispersions may be inappropriate for applications that require pure nanotubes. Under some situations, nanotubes can be deposited with spin coating, but for the thinnest films (<1 µm), it is difficult to obtain adequate uniformity. Drop casting suffers from inhomogeneities as the nanotubes flocculate in the solvent. Additional inhomogeneities appear as surface tension causes the last of the drying solvent to collect into discrete droplets. Airbrushing can be viewed as operating between two extremes in which the solids, entrained in the solvent, arrive at the surface either very wet or very dry (the bulk of the solvent evaporates as the droplets progress from the nozzle to the surface). The first case (wet deposition) leads to the same problems encountered in drop drying. The second case (nearly dry deposition) deposits discrete clumps of balled up nanotubes, with minimum inter-penetration of nanotubes between the optically dense clumps. Achieving the perfect, intermediate, in-flight drying consistency is elusive. Flocculation of the nanotubes in the solvent prior to exiting the nozzle remains a problem. The layer-by-layer deposition method could perhaps yield films of suitable homogeneity, but the method is relatively slow and difficult to apply on a large scale.

Accordingly, it was an object of the present invention to provide for a method of producing a film of carbon nanotubes on substrates in which the film is homogeneous. Moreover, it was an object of the present invention to provide for a method of producing a film of carbon nanotubes on a substrate that allows a control of the density of nanotubes within the film and the film thickness. Also it was an object of the present invention to provide for a method of producing a carbon nanotube film on a substrate that can be applied on a large scale.

All the objects of the present invention are solved by a method of producing a film of carbon nanotubes on a substrate, comprising the steps:
a) providing a substrate having a surface,
b) treating said surface with a polyhydric compound, to yield a treated surface having hydrogen-bond forming groups,
c) providing a solution or suspension of carbon nanotubes and applying a layer of such solution or suspension on said treated surface, drying said layer or allowing said layer to dry, said layer thereby forming a film of carbon nanotubes on said surface of said substrate.

In one embodiment, said treated surface has a static contact angle of water in the range of from 0 degrees to 90 degrees, preferably from 10 degrees to 90 degrees, more preferably from 30 degrees to 90 degrees and even more preferably from 50 degrees to 90 degrees.

In one embodiment said hydrogen-bond forming groups of said polyhydric compound are OH-groups, preferably hydroxyl groups of organic alcohols.

In one embodiment said polyhydric compound comprises a polyhydric polymer wherein, more preferably, said polyhydric polymer is a polymer comprising polyvinyl alcohol. In this context, the term "comprising" when used in connection with "polyhydric compound" or "polyhydric polymer" is meant to signify that such compound or polymer may have other components as well.

For example, the phrase "said polyhydric polymer is a polymer comprising polyvinyl alcohol" is meant to signify that this polyhydric polymer may have additional components present in its polymeric structure, such that the polyvinyl alcohol is copolymerized with other components or mixed otherwise with other components to make up the polyhydric polymer. Likewise, the phrase "said polyhydric compound comprises a polyhydric polymer" is meant to signify that the polyhydric compound, in addition to the polyhydric polymer, may have other substances/compounds/polymers present which may be in mixture with the polyhydric polymer or may be covalently or otherwise chemically bonded thereto.

In one embodiment said polyhydric polymer is polyvinyl alcohol.

The term "is", as used in the phrase "said polyhydric polymer is polyvinyl alcohol", is meant to signify that the polyhydric polymer, to the extent measurable, is polyvinyl alcohol and includes no other components, apart from unavoidable impurities.

Preferably, said polyvinyl alcohol has the formula [-CH₂CHOH-]ₙ, wherein n is selected from the range 50 to 5000.

In one embodiment said polyvinyl alcohol has a molecular weight in the range of from 4000 to 200000, preferably 4000 to 40000, more preferably 11000 to 24000.

In one embodiment said polyvinyl alcohol has the formula [-CH₂CHOR-]ₙ, wherein n is selected from the range 50 to 5000, and wherein the R group is either H or COCH₃ (acetyl) and the percentage of R groups that are H is selected from the range 50% to 100%.

In one embodiment step b) occurs by applying a solution, preferably an aqueous solution, of said polymeric compoundonto said surface, wherein, more preferably, said applying occurs by a technique selected from spin-coating, dipping, drop-casting, spraying,. and printing including inkjet printing and microcontact printing).

In one embodiment, prior to step b), said substrate having a surface is a substrate having a static contact angle of water in the range of from 60 degrees to 120 degrees, preferably from 65 degrees to 105 degrees.

In one embodiment, said substrate is a polymeric substrate.

Preferably, said substrate, preferably said polymeric substrate comprises at least one polymer or polymer blend having carbonyl groups in the backbone or in a side group of the polymer or polymer blend.

In one embodiment said substrate, preferably said polymeric substrate comprises at least one polymer or a polymer blend, said polymer and/or said polymer blend being selected from the group comprising polyesters of carboxylic acids, polyanhydrides of carboxylic acids, polycarbonates, and mixtures thereof.

In one embodiment said substrate, preferably said polymeric substrate comprises at least one polymer selected from the group comprising poly(methyl methacrylate), polyethylene terephthalate, cellulose acetate and poly(oxycarbonyloxo-1,4-phenylene-isopropylidene-1,4-phenylene) (polycarbonate).

In one embodiment said carbon nanotubes are dissolved or suspended in water with a concentration in the range of from 0.01 g/l to 10 g/l, or are dissolved or suspended in methanol or ethanol with a concentration in the range of from 0.01 g/l to 1 g/l, to provide a solution or suspension of carbon nanotubes to be used in step c).

Preferably, said carbon nanotubes have hydrogen-bond forming groups on their surface(s). More preferably, said hydrogen-bond forming group is a carbonyl group.

In a preferred embodiment said carbon nanotubes have carboxyl (-COOH), amido (-NHCO-) and/or ureido (-NHCONH-) groups on their surface(s), wherein, preferably, said carbon nanotubes have primary amido (-CONH₂) and/or primary ureido (-NHCONH₂) groups on their surface(s).

In one embodiment said solution or suspension of carbon nanotubes is an aqueous solution or suspension of carbon nanotubes, or an alcoholic, preferably methanolic or ethanolic or a mixture thereof, solution or suspension of carbon nanotubes, or a mixture of an aqueous and alcoholic solution or suspension of carbon nanotubes.

In one embodiment said carbon nanotubes, prior to dissolving or suspending them in an appropriate medium, such as an aqueous or alcoholic solvent, have been prepared by heating them in the presence of urea, optionally also in the presence of at least one aldehyde.

Preferably, said carbon nanotubes are single-walled, double-walled, or multi-walled nanotubes or a mixture thereof.

In one embodiment said applying a layer of a solution or suspension of carbon nanotubes in step c) on said treated surface occurs by a technique selected from spin coating, dipping, drop casting, spraying, and printing (including inkjet printing and microcontact printing)

Preferably, said film of carbon nanotubes on said surface is a film having a coverage in the range of from submonolayer to multilayer. In one embodiment, said film is deposited in several layers, preferably by repeating step c) several times. A film having the coverage of a multilayer structure, which comprises several monolayers of carbon nanotubes, can be prepared by adjusting the concentration of the carbon nanotube solution/suspension to such a level that this will lead to several monolayers of carbon nanotubes on top of each other on the surface. It is to be noted that such a film having a multilayer coverage may be deposited in one step, i.e. with performing step c) only once. The determination of appropriate concentrations of carbon nanotubes can be done by a person skilled in the art without undue burden of experimentation.

In the embodiments, where the film of carbon nanotubes is deposited in several layers by repeating step c), the film is applied in more than one deposition step (step c)). During each of these deposition steps, a layer of carbon nanotubes is applied which itself may have a coverage in the range of from submonolayer to multilayer.

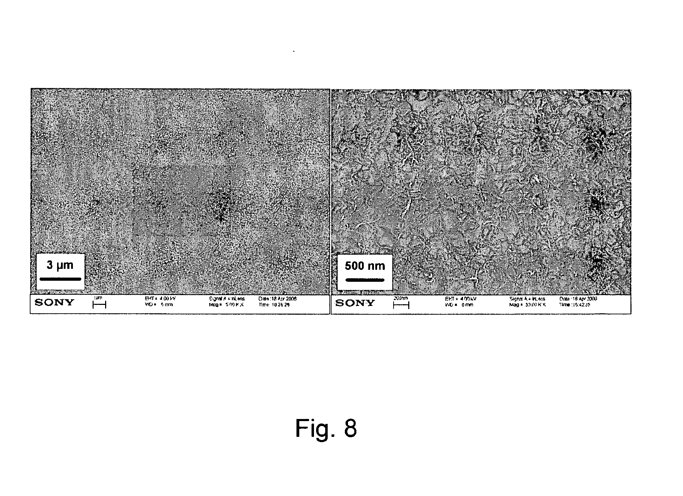

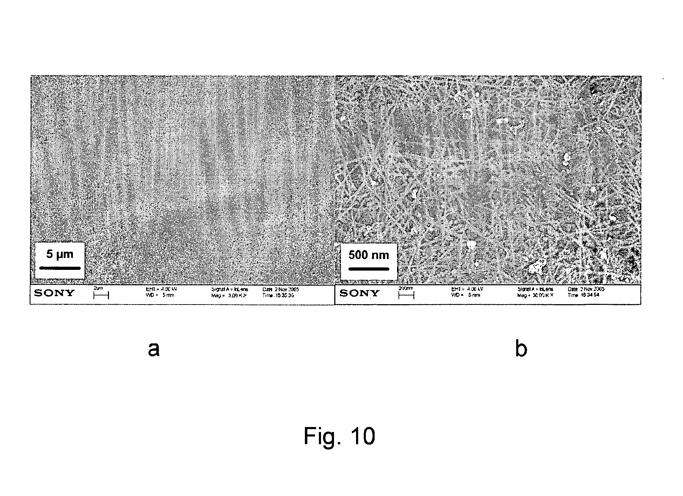

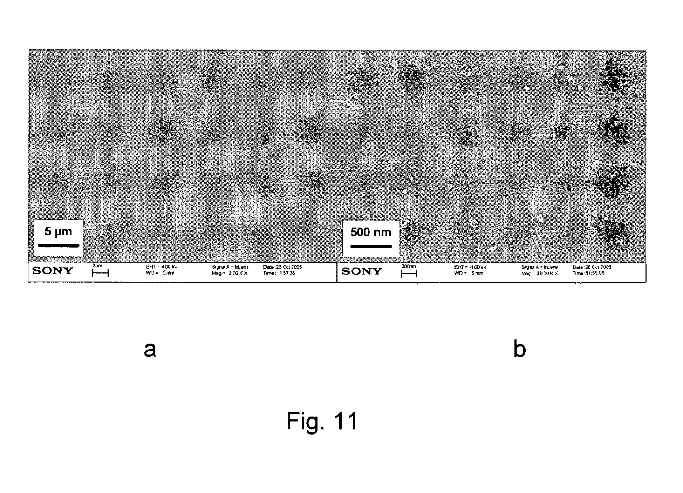

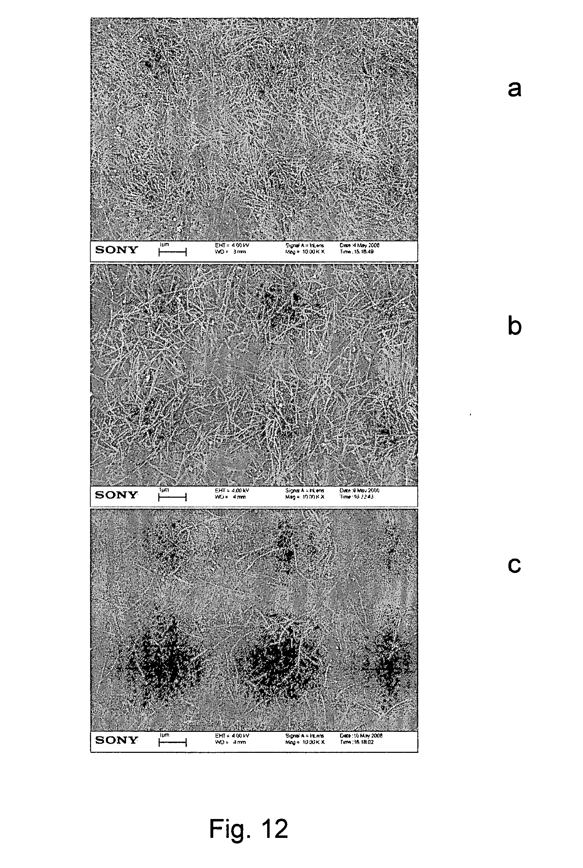

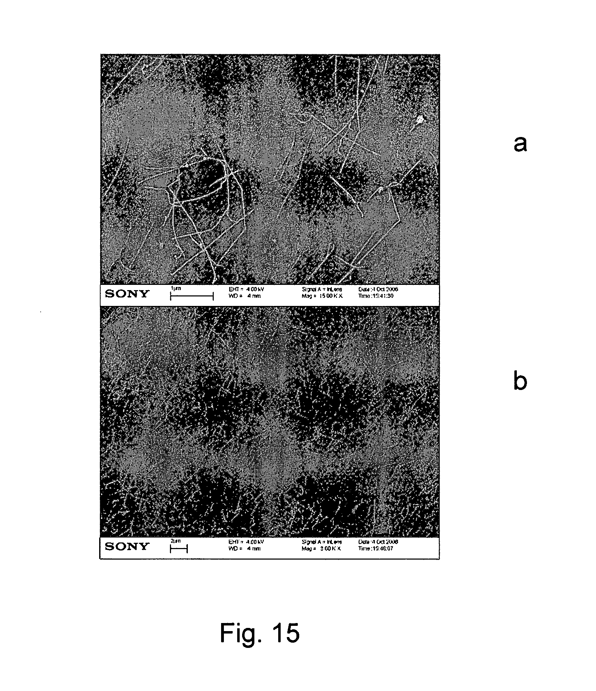

The term "coverage" when used in connection with a film, is usually meant to refer to the density and/or thickness at which the film covers a surface underneath the film. If a film is herein described as having a "coverage in the range of from submonolayer to multilayer", this is meant to signify that the film covers a surface underneath the film as a submonolayer, a monolayer or a multilayer of carbon nanotubes. Generally, a "monolayer" refers to a single layer of closely packed molecules or atoms, and the term "submonolayer" refers to an incomplete monolayer of molecules or atoms. More specifically, however, when these terms are used in connection with a film of carbon nanotubes, the term "monolayer" refers to a single layer of closely packed nanotubes, but the nanotubes are not necessarily uniform in length, diameter, or degree of bundling, nor does the packing need to be ordered. Hence, a monolayer of carbon nanotubes is not as well-defined as a monolayer of molecules or atoms. Furthermore, the description of a film of nanotubes may be further complicated by the possible presence of particulate contaminants. Hence, a "monolayer of carbon nanotubes" does not necessarily cover a surface underneath the monolayer at 100 % due to small holes in the monolayer which may be present. An example of such monolayer is shown in Figure 11. Consequently, a film of carbon nanotubes on a surface may also be described in terms of the surface area that is covered by the nanotubes or, synonymously, by the "surface coverage by nanotubes" ("S_{NT}"). With reference to the figures one may distinguish between three different scenarios for a single layer of carbon nanotubes, with the term "single layer of carbon nanotubes" including both "monolayer" as well as "submonolayer" of carbon nanotubes: in the first scenario, the surface coverage by nanotubes is S_{NT} > 90 %, as can for example be seen in Figure 11. In the second scenario the surface coverage by nanotubes is > 10 % but < 90 %, hence, 10 % < S_{NT} < 90 %, as can for example be seen in Figure 8 and 10. In the third scenario the surface coverage by nanotubes is < 10 %, hence S_{NT} < 10 %, as can for example be seen in Figure 15 and in Figure 12 c. The term "multilayer" of carbon nanotubes refers to a film of carbon nanotubes which covers the surface underneath the film in several monolayers which are on top of each other.

The objects of the present invention are also solved by a film of carbon nanotubes on a surface, prepared by the method according to the present invention.

Preferably, said film is a two-dimensional network of carbon nanotubes deposited on a substrate.

The term "two-dimensional network of carbon nanotubes", as used herein, refers to a film of carbon nanotubes wherein the term "two-dimensional" is meant to signify that the film is restricted to a plane, which is defined by the surface of the substrate on which the film of carbon nanotubes is supported. However, the term "two-dimensional" does not imply that such film is necessarily flat. Rather, this term is meant to include monolayers, submonolayers as well as multilayered structures of carbon nanotubes. In one embodiment such "two-dimensional network of carbon nanotubes" is a random network of carbon nanotubes. In another embodiment such two-dimensional network of carbon nanotubes is an aligned network of carbon nanotubes. It should however, be noted that the boundaries between the two embodiments may be not entirely clear cut, and there may be an overlap between the two embodiments, in that, for example a "random network" may also include certain areas with some alignment which areas on their own could not be referred to as "random" anymore. The term "random", as used herein, is meant to refer to a lack of defined pattern or organisation in which the carbon nanotubes are arranged in the film. It should, however, be noted that the term "random" in this context may include also networks wherein the nanotubes are not necessarily completely randomly oriented. There may, for example be a partial alignment depending on the experimental procedure by which the film is applied on the surface. For example, if spin-coating is used for such application of a film, there may be a partial alignment due to centripetal forces. Moreover, other coating methods, such as dip-coating, can also lead to a partial flow alignment of the nanotubes. The partially non-random structures are meant to be included herein, if they occur, even when the entire network is herein referred to as being "random". The term "network" as used in this context, is meant to refer to an interconnected group of carbon nanotubes. In the examples that are shown in the context of the present application, the inventors mostly used single-walled carbon nanotubes, wherein there may be a certain degree of organisation in that the carbon nanotubes may be packed together parallel to one another in "carbon nanotube bundles" which are about 10 nm in diameter which may for example contain approximately 10² nanotubes. In these examples, it is such bundles of carbon nanotubes that are forming a two-dimensional random network of carbon nanotubes.

Preferably, said film has a coverage in the range of from submonolayer to multilayer.

In one embodiment, the film according to the present invention comprises an electrically conductive two-dimensional network of carbon nanotubes deposited on a substrate with an optical absorbance at the wavelength of 550 nm in the range of from 0.001 to 1 and with a sheet resistance in the range of from 10 Ω per square to 10 MΩ per square.

The term "sheet resistance" is used herein synonymously with the term "sheet resistivity". It is meant to refer to a measure of resistivity of thin films which have an approximately uniform thickness, such as may be found in monolayers, submonolayers or multilayers of carbon nanotubes. It refers to a resistivity when an electrical current is passing across a film, and not through the film. The sheet resistance per square is given, for a film of thickness t, by R_{S} = ρ/t, where ρ is the resistivity of the material comprising the film. Strictly speaking, the unit for sheet resistance is the ohm (Ω), but to avoid confusion between resistance (R) and sheet resistance (R_{S}), sheet resistance is specified in unit of "ohms per square" (ohms/square). The term "ohms/square" is used because it gives the resistance in ohms of current passing from one side of a square region to the opposite side, regardless of the size of the square.

In an alternative embodiment, the film according to the present inventions comprises an electrically non-conductive two-dimensional network of carbon nanotubes deposited on a substrate with an optical absorbance at the wavelength of 550 nm less than 0.01.

The electrical conductivity of a film of carbon nanotubes depends on the density of nanotubes in the film. Such density of carbon nanotubes in a film may be described by reference to percolation theory. Generally speaking, in mathematics, percolation theory describes the behaviour of connected clusters in a random graph. If the carbon nanotubes in the film are at or above a "percolation threshold" value, this is meant to signify that the carbon nanotubes have a density in the film at which they form a connected network thus allowing electrical conduction across the film. A network of carbon nanotubes with a density near or below the percolation threshold has few or no conductive paths through the film. Such carbon nanotube networks will necessarily be submonolayer, as they do not form an interconnected network of nanotubes. Such films are, however, herein also sometimes referred to as an "electrically non-conductive two-dimensional random network of carbon nanotubes". It should be noted that these films are referred to as "networks" as well, even though there really is no long-range interconnection between the carbon nanotubes in it. Films of carbon nanotubes having a density of nanotubes at or above the percolation threshold form an interconnected network of carbon nanotubes and have conductive paths through the film. The same applies to films with thicknesses greater than a single monolayer, because in these multilayer structures, the conductive paths are not restricted to two dimensions, thus providing lower sheet resistance.

The objects of the present invention are also solved by a use of a film according to the present invention as an electronic material for applications including energy applications (solar cells, solid state lighting), electronics (passive and active matrix displays, smart windows), appliances (touch screens, defrosting windows), and security (RFID tags, electromagnetic shielding and sensors).

The films according to the present invention have numerous applications, including but not limited to transparent conductive films, electrostatic shielding, static charge dissipation, flat-panel displays, paper-like displays, fuel cells, touch screen panels, solar cells, sensors, actuators, thin film speakers, smart windows, radio frequency identification tags (RFIDs), wearable electronics, plastic electronics, flexible thin-film transistors, field-effect transistors, wherein, depending on the density of the nanotubes, the films can serve as channel, gate electrode or source/drain electrode, pick-up stick transistors, solid-state lighting and light-emitting diodes. Pick-up stick transistors wherein non-conductive two-dimensional carbon nanotube networks are used, have for example been described by Bo et al. in "Applied Physics Letters" 86, 2005, 182102. Where a non-conductive two-dimensional carbon nanotube network is used in a pick-up stick transistor, the nanotubes serve as "wires" within a semiconducting matrix which itself forms the channel of a field effect transistor. It is important to note, however, that the wires themselves do not form a percolating network, and therefore the channel is not short-circuited by them. In effect, therefore, the wires serve to shorten the channel length.

In many of the above examples, the film according to the present invention acts as and is used as a conductive surface or electrode. Generally, in one embodiment, where the network is electrically conductive, it is used as an electrically conductive surface or electrode.

The films according to the present invention may be used as an electrically conductive surface or semiconductive surface, if the films themselves are electrically conductive or semiconductive. In another embodiment, the films according to the present invention may be used in an electrically conductive or semiconductive surface. In this case, they do not necessarily have to be electrically conductive or semiconductive, respectively; all that is required by this limitation is that then the films according to the present invention be incorporated in such an electrically conductive or semiconductive surface.

The term "polyhydric compound", as used herein, is meant to refer to a compound which is polyhydric or a mixture of compounds at least one of which is polyhydric, and which compound or mixture of compounds facilitate the adhesion of another chemical entity, such as a further compound or particles, such as nanoparticles or nanotubes, to the surface of a substrate. Hence such "polyhydric compound" acts as an adhesion promoting agent and may also be referred to herein as a "polyhydric adhesion promoting agent". In preferred embodiments of the present invention, the polyhydric compound makes the surface of an otherwise hydrophobic substrate more hydrophilic and thereby amenable to adhesion of hydrophilic entities, such as water-soluble or alcohol-soluble nanoparticles or nanotubes. More particularly, and without wishing to be bound by any theory, the polyhydric compound provides hydroxyl groups on the surface of the substrate which can form hydrogen-bonds with carbonyl groups that are located on the nanotubes.

"Polyhydric", as used herein, is meant to refer to a functional group or discrete compound or polymer containing more than one hydroxyl group. Sugars (fructose, sucrose, or raffinose) and polyhydric alcohols (sorbitol or mannitol) are examples of discrete polyhydric organic compounds. Such compounds can be grafted to surfaces by standard covalent chemical coupling reactions. Glycation, for example, is a reaction that occurs between the reducing ends of sugar molecules, including common monosaccharides such as glucose and disaccharides such as lactose, and amino groups on the surface of a substrate to form a Schiff's base linkage, which can undergo an Amadori rearrangement to form a stable ketoamine derivative, resulting in a substrate with polyhydric sugar residues on its surface. The condensation reactions of aldonic acids, such as lactobionic acid, and aldonic acid lactones, such as gluconolactone, with amino groups on the surface of a substrate are another method to produce a substrate with polyhydric sugar residues on its surface. Amino groups can be introduced onto surfaces by various methods, including, for example, silanization with 3-aminopropyltriethoxysilane.

"Polyhydric polymer", as used herein, is meant to refer to molecules consisting of structural units and a large number of repeating units connected by covalent chemical bonds, wherein at least one of the structural and/or repeating units contains one or more hydroxyl group. Polysaccharides represent a broad range of naturally occurring polyhydric polymers. Synthetic polyhydric polymers with pendant saccharide moieties, so-called glycopolymers, are also known. Commercially, the perhaps most important synthetic polyhydric polymer is polyvinyl alcohol, which is prepared by partial or complete hydrolysis of polyvinyl acetate to remove acetate groups.

A "contact angle of water", as used herein, is meant to refer to the angle at the three-phase contact line for water/air/dry surface. A "static contact angle of water", as used herein, is meant to refer to the contact angle that is measured in a static condition, i.e., when the three-phase contact line is not moving. Sometimes, in this application, reference is made to a static contact angle of water of zero degrees. As used herein, such a value of zero degrees is usually meant to refer to a scenario wherein a liquid droplet spreads completely on a solid surface for which it has a strong affinity. Such a scenario is also sometimes referred to as "total wetting", and the effective contact angle is zero degrees. The measurement of contact angles is known to a person skilled in the art and has for example been reviewed by de Gennes (Reviews of Modem Physics 57, 827-836, (1985)).

As used herein, the term "solution of carbon nanotubes" is meant to refer to a molecularly dispersed distribution of carbon nanotubes or bundles of carbon nanotubes within a solvent. A "suspension" of carbon nanotubes is meant to refer to a dispersion of nanotubes within a solvent, wherein the nanotubes or bundles of nanotubes are not molecularly dispersed but may form larger aggregates.

As used herein, a carbonyl group is a functional group composed of a carbon atom double-bonded to an oxygen atom (C=O). Functional groups that contain one or more carbonyl groups include carboxylic acid, amide, urea, aldehyde, ketone, and quinone.

In many instances, carbon nanotubes are largely insoluble in most common solvents. In a preferred embodiment of the method according to the present invention, the carbon nanotubes that are used have been made more soluble in aqueous or alcoholic solution by treating them in the presence of a urea melt. Such solubilisation reactions are known to a person skilled in the art and have for example comprehensively described in International Patent Application PCT/EP2003/010600, published as WO 2004/052783. That application describes the production of carbon nanotubes having a solubility in water in the range of from 0.1 g/l to 10 g/l and/or in C₁, C₂, C₃ or C₄-alcohol, preferably in methanol, of from 0.1 g/l to 1 g/l. The content of that application with respect to possible methods of solubilisation of carbon nanotubes, is herein incorporated by reference in its entirety. Other possibilities of solubilizing carbon nanotubes, other than by using a urea melt, are also described in that application and are also envisaged for the present application, namely reactions with cyanic acid or isocyanic acid. Also, WO 2004/052783 describes the possibility of including at least one aldehyde in the reaction mixture when the carbon nanotubes having a solubility in water in the range of from 0.1 g/l to 10 g/l are prepared. Also this part of WO 2004/052783 is explicitly incorporated into the present application by reference thereto More specifically, the at least one aldehyde which may be present in the mixture for preparing the aforementioned carbon nanotubes having a solubility in water in the range of 0.1 g/l to 10 g/l is selected from the group comprising acetaldehyde, benzaldehyde, carboxyaldehyde, cinnamaldehyde, chlorobenzaldehyde, ferrocene carboxaldehyde, formaldehyde, furfural, glutaraldehyde, paraformaldehyde, polyhydroxyaldehyde, propionaldehyde, pyridine aldehyde, salicylaldehyde and valeraldehyde.

The term "polyhydroxyaldehyde" refers to a class of carbohydrate including aldoses. An aldose is a monosaccharide sugar that contains the aldehyde group (-CHO). An aldose can further be classified as aldotriose, aldotetrose, aldopentose, and aldohexose, depending on the number of carbon atoms in the sugar. Examples of these are glyceraldehyde (an aldotriose), erythrose (an aldotetrose), ribose (an aldopentose), and glucose (an aldohexose). Aldopentose and aldohexose compounds exist in aqueous solution in equilibrium with their five or six member ring hemiacetal forms. Certain di-, tri-, and polysaccharides that contain aldose components are also polyhydroxyaldehyde compounds according to the present invention. Examples of disaccharides that are polyhydroxyaldehydes are maltose and lactose.

Preferably the benzaldehyde is substituted with at least one electron-donating group, selected from -NHR, -NRR', -OH, -OR, -C₆H₅, -CH₃, -CH₂R, -CHR₂ and CR₃, wherein R and R' represent linear or branched C₁-C₁₂ alkyl groups, C₃-C₈ cycloalkyl groups, C₆-C₁₂ aralkyl groups, C₆-C₁₂ aryl groups, poly(ethylene oxide), poly(propylene oxide), and poly(ethylene oxide)-co-poly(propylene oxide)block co-polymers.

In one embodiment, the at least one electron-donating group on benzaldehyde is in the para-position.

Preferably, the at least one electron-donating group on benzaldehyde is -OH or -OR, wherein R represents a linear or branched C₁-C₁₂ alkyl group, a C₃-C₈ cycloalkyl group, a C₆-C₁₂ aralkyl group, a C₆-C₁₂ aryl group, poly(ethylene oxide), poly(propylene oxide), or poly(ethylene oxide)-co-poly(propylene oxide)block co-polymer.

More preferably, the at least one aldehyde is selected from the group comprising p-anisaldehyde, 4-propoxybenzaldehyde and 4-(hexyloxy)benzaldehyde.

If the aldehyde is added before and/or during polymerization, in one embodiment of the method according to the present invention, it should have a boiling point greater than approximately 100°C. Paraformaldehyde is a non-volatile polymeric form of formaldehyde that depolymerizes to formaldehyde. Benzaldehyde and glutaraldehyde are common aldehydes with high boiling points (>170°C).

The criterion for the boiling point of the aldehyde in this particular embodiment, is that the aldehyde can be present during the polymerization long enough to react without evaporating completely.

Without wishing to be bound by any theory, the present inventors believe that the treatment of carbon nanotubes with a urea melt allows the conversion of oxygen-containing functional groups that may be present on the ends and/or sidewalls of the nanotubes into amido, ureido, or polyureido groups, providing nanotubes whose solutions or suspensions in polar solvents are highly stable due to the presence of these groups. Furthermore, condensation reactions occur between these amido, ureido, or polyureido groups and aldehyde groups of aldehyde-containing compounds when such compounds are mixed with the urea-modified nanotubes, thereby modifying the solubility properties of the nanotubes and/or providing a means of introducing additional functionalities thereon.

The "polyvinyl alcohol", as used herein, is a polymeric compound. It is clear to a person skilled in the art that, although herein, the singular is used in reference to such polyvinyl alcohol, this may comprise a variety of species, both in terms of structure as well as molecular weight. Hence, such polyvinyl alcohol is herein usually referred to as having a molecular weight in a specified range. In preferred embodiments, the molecular weight of the polyvinyl alcohol according to the present invention is in the range of from 5000 to 200000, more preferably from 10000 to 30000.

Without wishing to be bound by any theory, the present inventors believe that the use of a polyhydric adhesion promoting agent makes surfaces which are otherwise hydrophobic, more amenable to the formation of films of carbon nanotubes on them. This is probably, because the wettability and possible interaction with carbon nanotubes through molecular interactions that include hydrogen bonding is improved by such polyhydric adhesion promoting agent. Preferably, the polyhydric adhesion promoting agent is a polymeric compound. This may be applied as such to the surface or it may be applied as solution, for example aqueous solution. In a preferred embodiment, after application of such solution, the solvent is allowed to evaporate or actively dried, and in any case, the result is a treated surface which has become more hydrophilic than previously.

In the following, a preferred embodiment is described, wherein polyvinyl alcohol is used as the polyhydric adhesion promoting agent.

### Preferred embodiment

Most of the purification methods that are currently used to purify carbon nanotubes (CNTs) can remove the end caps and oxidize the sidewalls and open ends leading to oxygen-containing functional groups. The nature and density of the functional groups introduced to the CNTs upon oxidation depend on the oxidation agent and conditions used, as well as the density of defects present. Oxidative attack at defect sites results in opening of the sidewall and can lead to the creation of functional groups that contain one or more carbonyl groups.

Functional groups that contain one or more carbonyl groups can also be attached to CNTs by various known covalent or non-covalent techniques, such as via the adsorption of a carbonyl-group-containing polymer like the sodium salt of alginic acid (structure I) or the adsorption of a carbonyl-group-containing surfactant like the sodium of deoxycholic acid (structure II).

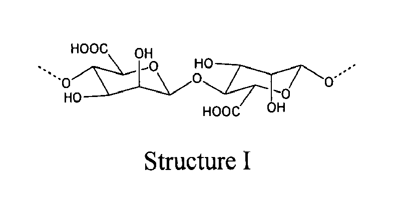

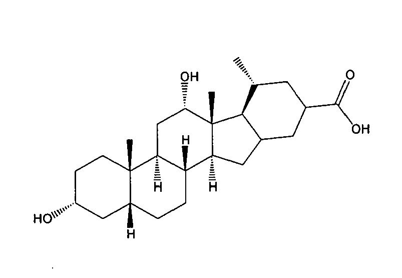

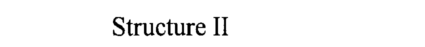

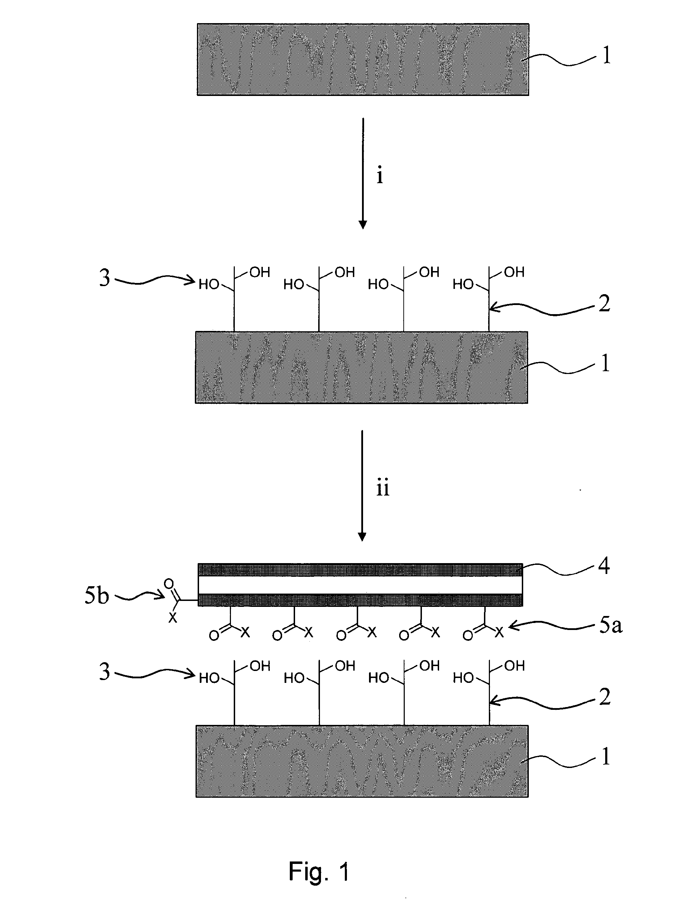

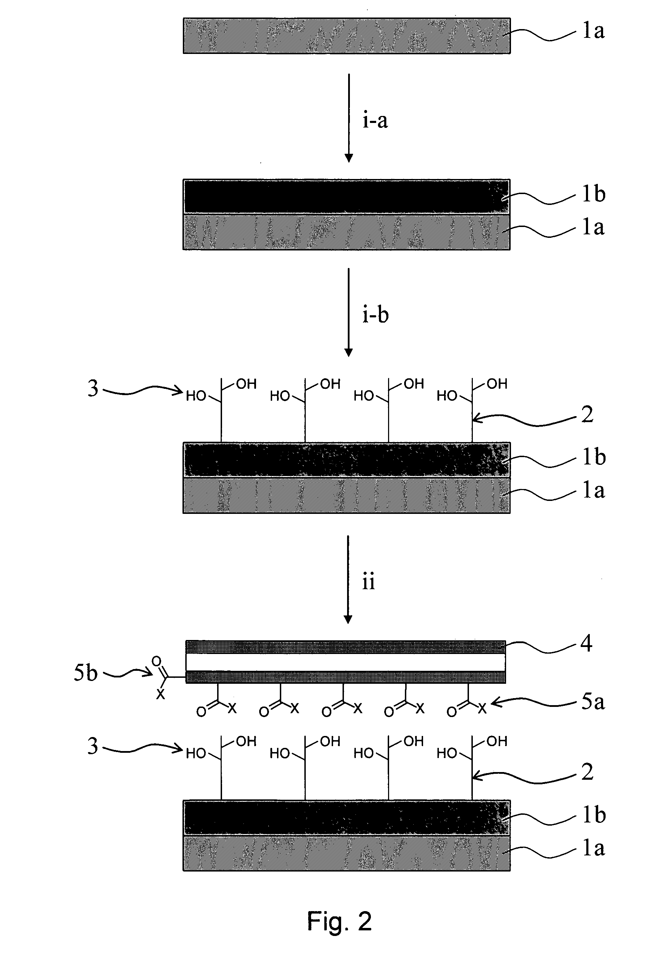

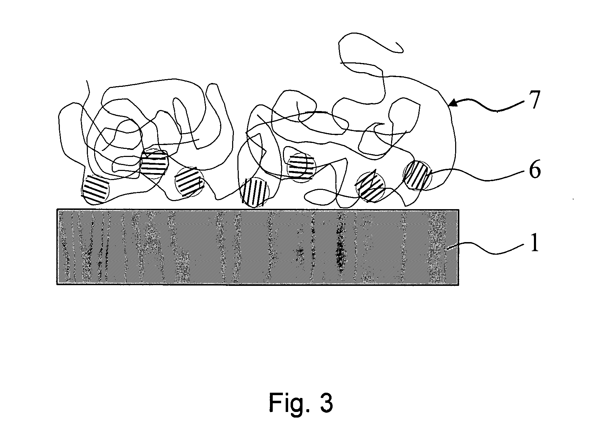

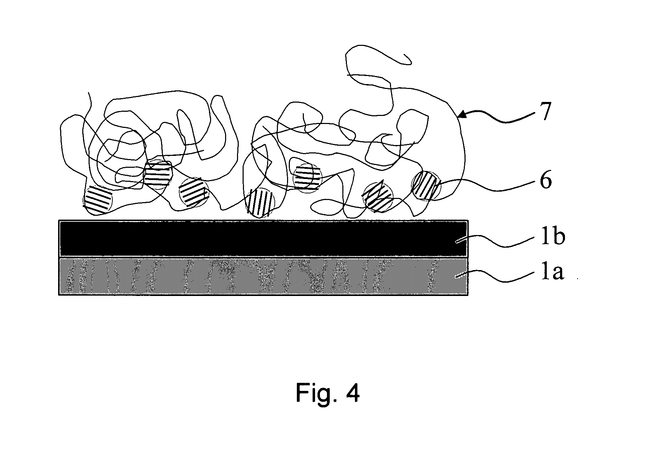

Carbon nanotubes (CNTs) with attached polar functional groups, such as carboxyl (-COOH), amido (-CONH₂), or ureido (-NHCONH₂), can form stable solutions or suspensions in polar liquids, such as water or a lower alcohol (methanol, ethanol, isopropanol). These nanotubes interact well with each other but not with most surfaces, so films prepared by liquid-based methods (i.e., spin-coating, dipping, drop-casting, spraying, or printing) suffer from poor homogeneity due to poor wetting of the surface of the substrate by the liquid as well as weak interaction between the surface and the nanotubes. Pretreatment of surfaces, particularly plastic surfaces (or polymer films), especially ones containing carbonyl (>C=O) functional groups, with polyvinyl alcohol [-CH₂CHOH-]ₙ, (also known as poly(vinyl alcohol) or PVA, and referred to herein as PVOH) results in adsorption of PVOH molecules thereby improving the substrate's wettability (lower contact angle) and interaction with the CNTs, through molecular interactions that include hydrogen bonding as indicated in FIGURE 1 and FIGURE 2. According to the results published by Kozlov et al. (Macromolecules 36, 6054-6059 (2003)), the adsorption of PVOH molecules onto hydrophobic surfaces is accompanied by crystallization of some segments to form crystallite domains that make the molecules insoluble in water at room temperature (FIGURE 3 and FIGURE 4). As a result of improved wettability after treating the substrate with PVOH, the liquid in which the nanotubes are dissolved or dispersed spreads uniformly on the surface of the pretreated substrate, and as a result of improved interaction with the nanotubes, their migration on the surface during drying of the liquid is prevented. Thus homogeneous thin films of soluble CNTs can be prepared via spin-coating onto substrates, including plastic substrates (or polymer films). The film thickness and/or nanotube density can be controlled by various process parameters such as nanotube concentration in the liquid, spin-coating rotation speed, and number of deposition steps.

Moreover, reference is made to the following figures, wherein
Figure 1 is a schematic representation of one embodiment of the general process steps for preparing a film of carbonyl group functionalized carbon nanotubes on a substrate surface-modified with a polyhydric group and the structural features thereof, wherein 1 represents a substrate, 2 represents the backbone of a polyhydric group attached to the surface of substrate 1, 3 represents an hydroxyl group attached to the backbone of the polyhydric group 2, 4 represents a carbon nanotube, and 5 represents a carbonyl group attached to the surface of carbon nanotube 4, at the end of the nanotube (5a) and/or on the sidewall of the nanotube (5b). The process steps indicated are i): attaching a polyhydric group to the surface of a substrate and ii): attaching carbonyl group functionalized carbon nanotubes to said substrate surface-modified with said polyhydric group. A single-walled carbon nanotube is indicated in the drawing, but it could alternatively be a double-walled or multi-walled nanotube, or a bundle of nanotubes. (Not drawn to scale.);
Figure 2 is a schematic representation of one embodiment of the general process steps for preparing a film of carbonyl group functionalized CNTs on a polymeric film supported on a substrate surface-modified with a polyhydric group and the structural features thereof, wherein 1a represents a substrate, 1b represents a polymer film on substrate 1a, 2 represents the backbone of a polyhydric group attached to the surface of polymer film 1b, 3 represents an hydroxyl group attached to the backbone of the polyhydric group 2, 4 represents a carbon nanotube, and 5 represents a carbonyl group attached to the surface of carbon nanotube 4, at the end of the nanotube (5a) and/or on the sidewall of the nanotube (5b). The process steps indicated are i-a): applying a polymer film to the surface of a substrate, i-b): attaching a polyhydric group to the surface of said polymer film, and ii): attaching carbonyl group functionalized carbon nanotubes to said polymer film surface-modified with said polyhydric group. A single-walled carbon nanotube is indicated in the drawing, but it could alternatively be a double-walled or multi-walled nanotube, or a bundle of nanotubes. (Not drawn to scale.);
Figure 3 is a schematic representation of a substrate surface-modified with polyvinyl alcohol molecules adsorbed from solution onto the surface of the substrate due to the formation of insoluble crystalline domains within the chains of the polyvinyl alcohol molecules, wherein 1 represents a substrate, 6 represents a crystalline domain of a polyvinyl alcohol molecule in the vicinity of the surface of substrate 1, and 7 represents an amorphous domain of a polyvinyl alcohol molecule extended from the surface of substrate 1. Hydroxyl groups attached to the polyvinyl alcohol molecules are not shown. (Not drawn to scale.);
Figure 4 is a schematic representation of a substrate surface-modified with polyvinyl alcohol molecules adsorbed from solution onto the surface of said substrate due to the formation of insoluble crystalline domains within the chains of the polyvinyl alcohol molecules, wherein 1a represents a substrate, 1b represents a polymer film on substrate 1a, 6 represents a crystalline domain of a polyvinyl alcohol molecule in the vicinity of the surface of polymer film 1b, and 7 represents an amorphous domain of a polyvinyl alcohol molecule extended from the surface of polymer film 1b. Hydroxyl groups attached to the polyvinyl alcohol molecules are not shown. (Not drawn to scale.);

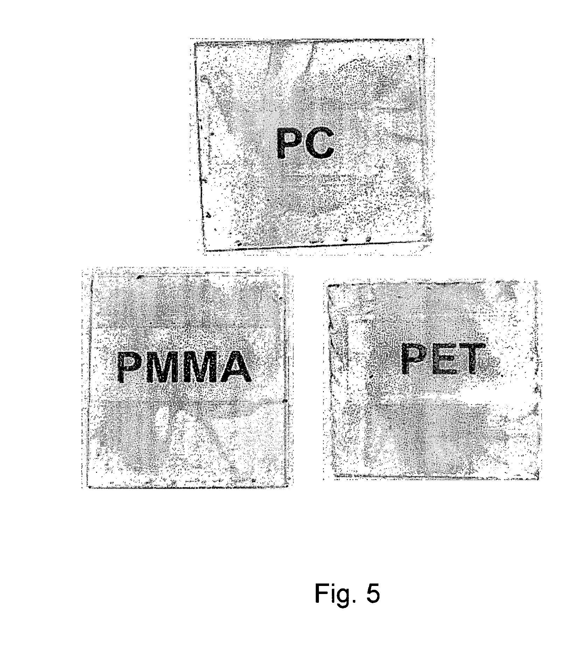

Figure 5 shows photographs of films of single-walled carbon nanotubes deposited from aqueous solution by spin-coating onto plastic sheets (PC, PMMA and PET; polycarbonate, polymethylmethacrylate, and polyethyleneterephthalate, respectively) that were previously treated with polyvinyl alcohol (PVOH) (EXAMPLE 1);

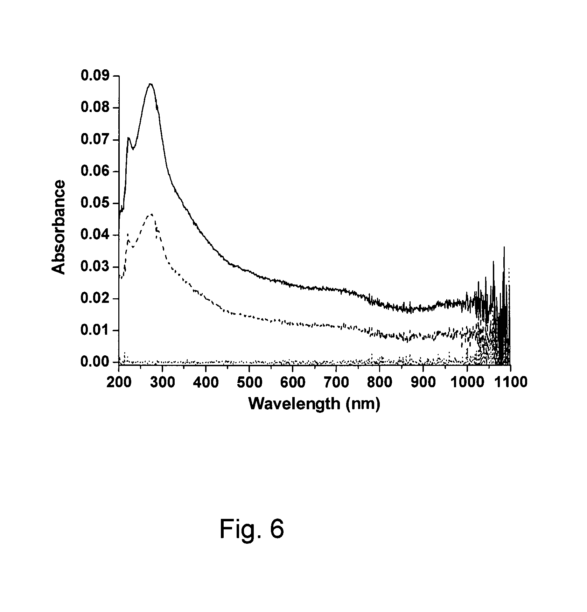

Figure 6 shows optical absorption spectra of films of single-walled carbon nanotubes deposited from aqueous solution by spin-coating onto a CaF₂/PMMA/PVOH substrate (EXAMPLE 2). The lower spectrum (dashed line) was measured after the first coating and the upper spectrum (continuous line) was measured after the second coating. Both spectra have absorption maxima near 270 nm that is characteristic of the single-walled carbon nanotubes. The baseline (dotted line) was measured with the substrate before deposition of the nanotubes;

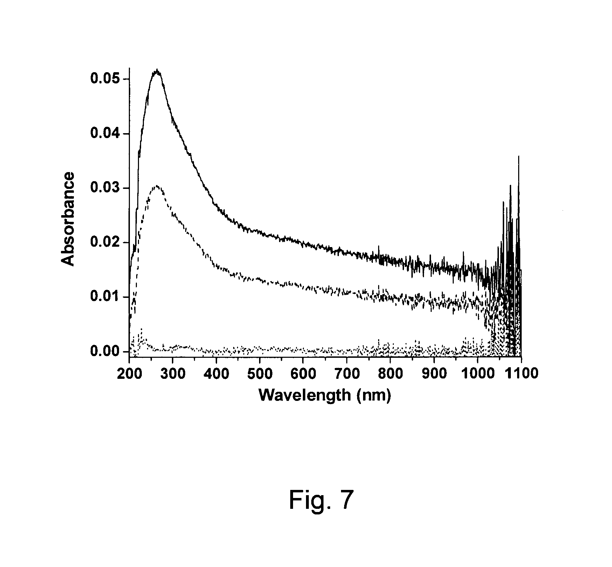

Figure 7 shows optical absorption spectra of films of multi-walled carbon nanotubes deposited from aqueous solution by spin-coating onto a CaF₂/PMMA/PVOH substrate (EXAMPLE 3). The lower spectrum (dashed line) was measured after the first coating and the upper spectrum (continuous line) was measured after the second coating. Both spectra have absorption maxima near 263 nm that is characteristic of the multi-walled carbon nanotubes. The baseline (dotted line) was measured with the substrate before deposition of the nanotubes;
Figure 8 shows scanning electron micrographs of a film of multiwalled carbon nanotubes after two depositions by spin-coating onto a CaF₂/PMMA/PVOH substrate (EXAMPLE 3). The dark rectangle in the image on the left side is the effect of electron beam irradiation during an earlier scan at higher magnification.

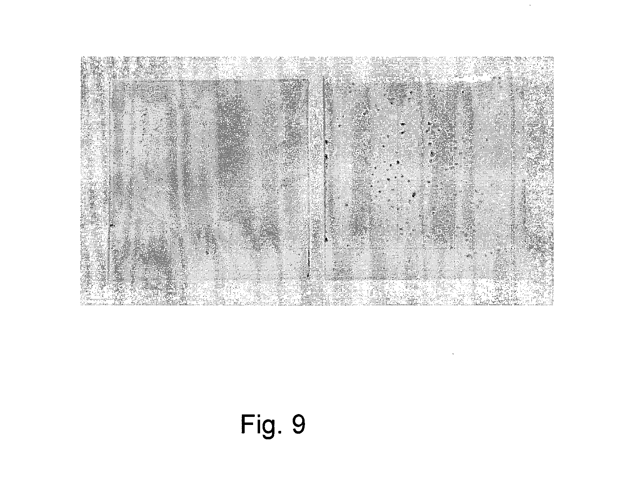

Figure 9 shows photographs of films of single walled carbon nanotubes after one deposition by spin-coating onto a glass-FTO/PMMA/PVOH substrate (left-hand side) and onto a glass-FTO/PMMA substrate (right-hand side) (EXAMPLE 4);
Figure 10 shows scanning electron micrographs of a film of single walled carbon nanotubes after one deposition by spin-coating onto a glass-FTO/PMMA/PVOH substrate (EXAMPLE 5) (two different magnifications, Fig. 10a and 10b);
Figure 11 shows scanning electron micrographs of a film of single walled carbon nanotubes after two depositions by spin-coating onto a glass-FTO/PMMA/PVOH substrate (EXAMPLE 5) (two different magnifications, Fig. 11a and 11b);
Figure 12 shows scanning electron micrographs of films of single walled carbon nanotubes after one deposition by spin-coating onto a glass-FTO/PMMA/PVOH substrate of solutions that were diluted to 50% (a), 33% (b), and 25% (c)(EXAMPLE 6);

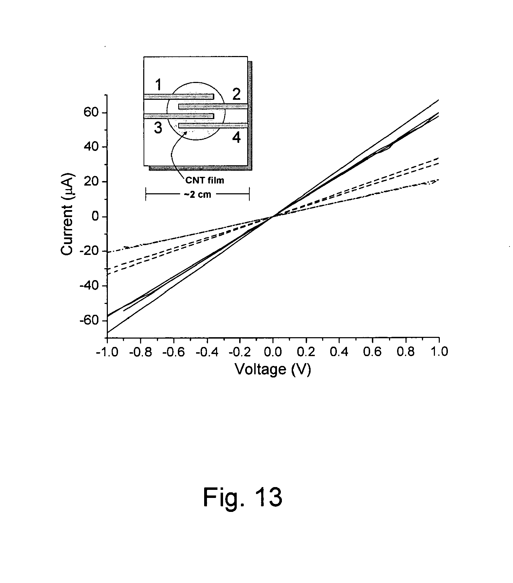

Figure 13 shows two-probe current versus applied voltage (*I-V*) behavior of a film of single walled carbon nanotubes. The sample was prepared by one spin-coating onto a glass/PMMA/PVOH substrate followed by evaporation of four interdigitated Pd/Au electrodes (EXAMPLE 7). The upper three measurements were made when the probes were contacting electrodes 1 & 2, 2 & 3 and 3 & 4, the middle two measurements were made when contacting electrodes 1 & 3 and 2 & 4, and the lower measurement was made when contacting electrodes 1 & 4 (Inset: schematic of arrangement of the electrodes);

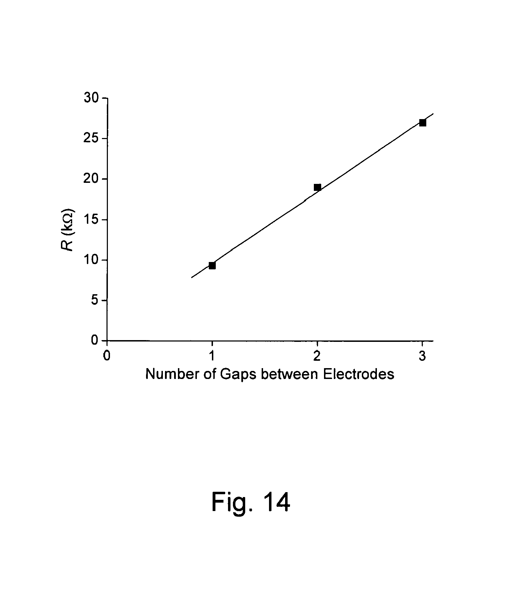

Figure 14 shows a plot of resistance versus number of gaps between the electrodes (values obtained from FIGURE 13) to estimate the sheet resistance of a film of single walled carbon nanotubes prepared by one spin-coating onto a glass/PMMA/PVOH substrate (EXAMPLE 7);
Figure 15 shows two different magnifications (a) and (b) of scanning electron micrographs of a film of double-walled carbon nanotubes after two depositions by spin-coating onto a Si/SiO₂/PMMA/PVOH substrate (EXAMPLE 8).

Moreover, reference is made to the following examples which are given to illustrate, not to limit the present invention.

### EXAMPLE 1

### Spin-coating of soluble single-walled carbon nanotubes onto polymer sheets surface-modified by adsorption with polyvinyl alcohol

Sheets of polycarbonate (PC), poly(methyl methacrylate) (PMMA), and polyethylene terephthalate (PET) (each 1-mm thick, obtained from Goodfellow Cambridge Ltd.) were cut into 23-mm square pieces, cleaned with Alconox detergent solution, rinsed thoroughly with water and dried. The static contact angle of a drop (20-50 µL) of water on the unmodified sheets was measured and the values are given in TABLE 1. Onto the unmodified sheets was placed 400 µL of a solution of polyvinyl alcohol (PVOH, molecular weight 13000-23000, 98% hydrolyzed, from Sigma-Aldrich Co.) in water with a concentration of 4 mg per mL (4%). The samples were kept at room temperature for 1 hour to allow adsorption of PVOH onto the surface, and then were spun at 3000 rpm for 60 seconds to produce a transparent film of PVOH. The sheets were then placed in a vessel of water (10 mL) to dissolve the non-adsorbed PVOH and dried. The static contact angle of a drop (20-50 µL) of water on the surface of the resulting PVOH-modified sheets was measured and the values are shown in TABLE 1. The fact that the contact angle of water on the modified sheets was significantly lower than on the unmodified sheets is evidence that PVOH molecules became adsorbed to the surface of the sheets, making them more hydrophilic and providing hydroxyl groups as attachment sites for carbonyl groups on the CNTs.

**TABLE 1: Static contact angle (in degrees) of a drop (20-50 µL) of water on the surface of polymeric substrates before and after surface modification by adsorption of polyvinyl alcohol**

| **Polymer** | **Form** | **Before** | **After** |
|---|---|---|---|
| Polycarbonate | Sheet | 85 ± 2 | 51 ± 2 |
| Poly(methyl methacrylate) | Sheet | 85 ± 5 | 78 ± 1 |
| Polyethylene terephthalate | Sheet | 84 ± 7 | 51 ± 2 |
| Poly(methyl methacrylate) | Film | 102 ± 4 | 82 ± 6 |
| Cellulose acetate | Film | 67 ± 3 | 59 ± 3 |
| Ethyl cellulose | Film | 120 ± 3 | 116 ± 4 |

A solution of urea-melt solubilized single-walled carbon nanotubes in water (25 µL, nanotube concentration ~2.7 g/L) was applied to each of the PVOH-modified sheets and then spun at 3000 rpm for 60 seconds to produce a transparent film of nanotubes. FIGURE 5 shows photographs of the resulting samples. The size of the circular domains approximately 15 mm in diameter in the middle of each sample where uniform films of the nanotubes are located was determined by the size of the solution applied before spinning. Each film was probed within the domain to determine the optical absorbance at 550 nm (average obtained at 7 positions with the absorbance of the sheet before application of the nanotubes as baseline) and electrical resistance (obtained by a 2-probe technique) and the results are given in TABLE 2.

**TABLE 2: Optical absorbance (at 550 nm) and electrical resistance of single-walled carbon nanotube films on polymer sheets surface-modified by adsorption of polyvinyl alcohol**

| **Polymer** | **Absorbance** | **Resistance (kΩ)** |
|---|---|---|
| Polycarbonate | 0.119 ± 0.003 | 31 ± 2 |
| Poly(methyl methacrylate) | 0.101 ± 0.003 | 52 ± 8 |
| Polyethylene terephthalate | 0.120 ± 0.002 | 59 ± 20 |

### EXAMPLE 2

### Spin-coating of soluble single-walled carbon nanotubes onto polymer films surface-modified by adsorption with polyvinyl alcohol

Onto a clean 20-mm diameter CaF₂ substrate was placed 100 µL of a solution of poly(methyl methacrylate) (PMMA, molecular weight ca 996000, from Sigma-Aldrich Co.) in toluene with a concentration of 4 mg per gram (4%) and then the sample was spun at 3000 rpm for 60 seconds to produce a transparent ~100-nm thick PMMA film on the substrate. Onto the PMMA film was placed 200 µL of a solution of PVOH (molecular weight 13000-23000, 98% hydrolyzed, from Sigma-Aldrich Co.) in water with a concentration of 4 mg per mL (4%). After 20-30 seconds, the sample was spun at 3000 rpm for 60 seconds to produce a transparent film of PVOH on the PMMA film. The bi-layered film was rinsed with several milliliters of water to dissolve the non-adsorbed PVOH and dried. The static contact angle of a drop (20-50 µL) of water on the PMMA film was measured before and after this treatment and the values are given in TABLE 1. The fact that the contact angle of water was significantly lower after the treatment than before is evidence that PVOH molecules became adsorbed to the surface of the PMMA film, making it more hydrophilic. A solution of urea-melt solubilized single-walled carbon nanotubes in water (25 µL, nanotube concentration ~1.3 g/L) was applied to the PVOH-treated film and then spun at 3000 rpm for 60 seconds to produce a uniform, transparent film of carbon nanotubes on the substrate. The absorbance at 550 nm of the nanotubes in the film was 0.0132 ± 0.0003 (average obtained at 5 positions). The spin-coating procedure was repeated and the absorbance at 550 nm of the nanotubes in the film after the second spin-coating was 0.0260 ± 0.0003 (average obtained at 5 positions). The UV-visible absorption spectra of this sample are shown in FIGURE 6.

Similar results were obtained with cellulose acetate (CA) instead of PMMA. A CaF₂ substrate was spin-coated with a solution of CA (39.8% acetyl, from Kodak) in acetone with a concentration of 2 mg per gram (2%) followed by treatment with a solution of PVOH and rinse with water. The values of static contact angle before and after treatment with PVOH are given in TABLE 1 and show that the surface was significantly more hydrophilic after the treatment, indicating that PVOH molecules became adsorbed to the surface of the CA film. A solution of urea-melt solubilized single-walled carbon nanotubes in water (25 µL, nanotube concentration ~2.7 g/L) was applied to the PVOH-treated film and then spun at 3000 rpm for 60 seconds to produce a uniform, transparent film of carbon nanotubes on the substrate. The absorbance at 550 nm of the nanotubes in the film was 0.0804 ± 0.0061 (average obtained at 5 positions).

Different results were obtained with ethyl cellulose (EC) instead of PMMA. A CaF₂ substrate was spin-coated with a solution of EC (48.0-49.5% ethoxyl, from Fluka) in 80/20 v/v toluene-ethanol with a concentration of 5 mg per gram (5%) followed by treatment with a solution of PVOH and rinse with water. The values of static contact angle before and after treatment with PVOH are given in TABLE 1 and show that the surface remained hydrophobic after the treatment, indicating that PVOH molecules did not become adsorbed to the surface of the EC film. A solution of urea-melt solubilized single-walled carbon nanotubes in water (25 µL, nanotube concentration ~2.7 g/L) was applied to the PVOH-treated film and then spun at 3000 rpm for 60 seconds, resulting in a spotty, inhomogeneous deposit of nanotubes on the substrate.

### EXAMPLE 3

### Spin-coating of soluble multi-walled carbon nanotubes onto a polymer film surface-modified by adsorption with polyvinyl alcohol

Onto a clean 20-mm diameter CaF₂ substrate was placed 100 µL of a solution of poly(methyl methacrylate) (PMMA, molecular weight ca 996000, from Sigma-Aldrich Co.) in toluene with a concentration of 4 mg per gram (4%) and then the sample was spun at 3000 rpm for 60 seconds to produce a transparent ~100-nm thick PMMA film on the substrate. Onto the PMMA film was placed 200 µL of a solution of PVOH (molecular weight 13000-23000, 98% hydrolyzed, from Sigma-Aldrich Co.) in water with a concentration of 4 mg per mL (4%). After 20-30 seconds, the sample was spun at 3000 rpm for 60 seconds to produce a transparent film of PVOH on the PMMA film. The bi-layered film was rinsed with several milliliters of water to dissolve the non-adsorbed PVOH and dried. A solution of urea-melt treated multiwalled carbon nanotubes in water (25 µL, nanotube concentration ~1.3 g/L) was applied and then spun at 3000 rpm for 60 seconds to produce a transparent film of carbon nanotubes on the substrate. The absorbance at 550 nm of the nanotubes in the film was 0.0132 ± 0.0003 (average obtained at 5 positions). The spin-coating procedure was repeated and the absorbance at 550 nm of the nanotubes in the film after the second spin-coating was 0.0260 ± 0.0003 (average obtained at 6 positions). The UV-visible absorption spectra of this film are shown in FIGURE 7 and SEM images are shown in FIGURE 8.

### EXAMPLE 4

### Comparison of samples prepared with and without surface modification with polyvinyl alcohol

Onto a clean 25 mm x 25 mm piece of electrically conductive glass (glass coated with fluorine-doped tin dioxide (glass-FTO)) was placed 100 µL of a solution of poly(methyl methacrylate) (PMMA, molecular weight ca 996000, from Sigma-Aldrich Co.) in toluene with a concentration of 4 mg per gram (4%) and then the sample was spun at 3000 rpm for 60 seconds to produce a transparent ~100-nm thick PMMA film on the substrate. Onto the PMMA film was placed 200 µL of a solution of PVOH (molecular weight 13000-23000, 98% hydrolyzed, from Sigma-Aldrich Co.) in water with a concentration of 4 mg per mL (4%). After 20-30 seconds, the sample was spun at 3000 rpm for 60 seconds to produce a transparent film of PVOH on the PMMA film. The bi-layered film was rinsed with several milliliters of water to dissolve the non-adsorbed PVOH and dried. A solution of urea-melt treated single-walled carbon nanotubes in water (25 µL, nanotube concentration ~2.7 g/L) was applied and then spun at 3000 rpm for 60 seconds to produce a transparent film of carbon nanotubes on the substrate. The absorbance at 550 nm of the nanotubes in the film was 0.0860 ± 0.0024 (average obtained at 5 positions). The experiment was repeated except that the PMMA film was not surface modified with PVOH, and a spotty rather than continuous film of nanotubes was obtained. FIGURE 9 shows photographs of the sample prepared with PVOH (left-hand side) and the sample prepared without PVOH (right-hand side).

### EXAMPLE 5

### Controlling single-walled carbon nanotube film density by multiple coatings

Onto a clean 25 mm x 25 mm piece of electrically conductive glass (glass coated with fluorine-doped tin dioxide (glass-FTO)) was placed 100 µL of a solution of poly(methyl methacrylate) (PMMA, molecular weight ca 996000, from Sigma-Aldrich Co.) in toluene with a concentration of 4 mg per gram (4%) and then the sample was spun at 3000 rpm for 60 seconds to produce a transparent ~100-nm thick PMMA film on the substrate. Onto the PMMA film was placed 200 µL of a solution of PVOH (molecular weight 13000-23000, 98% hydrolyzed, from Sigma-Aldrich Co.) in water with a concentration of 4 mg per mL (4%). After 20-30 seconds, the sample was spun at 3000 rpm for 60 seconds to produce a transparent film of PVOH on the PMMA film. The bi-layered film was rinsed with several milliliters of water to dissolve the non-adsorbed PVOH and dried. A solution of urea-melt treated single walled carbon nanotubes in water (25 µL, nanotube concentration ~1.3 g/L) was applied and then spun at 3000 rpm for 60 seconds to produce a transparent film of carbon nanotubes on the substrate. Scanning electron microscopy (SEM) images of the film after a single coating are shown in FIGURE 10. SEM images of the film after a second coating are shown in FIGURE 11.

### EXAMPLE 6

### Controlling single-walled carbon nanotube film density by dilution of the spin-coated solution

Onto a clean 6 mm x 6 mm piece of silicon with a 500-nm oxide layer was placed 20 µL of a solution of poly(methyl methacrylate) (PMMA, molecular weight ca 996000, from Sigma-Aldrich Co.) in toluene with a concentration of 3 mg per gram (3%) and then the sample was spun at 3000 rpm for 60 seconds to produce a transparent ~50-nm thick PMMA film on the substrate. Onto the PMMA film was placed 30 µL of a solution of PVOH (molecular weight 13000-23000, 98% hydrolyzed, from Sigma-Aldrich Co.) in water with a concentration of 4 mg per mL (4%). After 60 seconds, the sample was spun at 3000 rpm for 60 seconds to produce a transparent film of PVOH on the PMMA film. The substrate was immersed in a bath of water (~5 mL) for 1 minute to dissolve the non-adsorbed PVOH and dried. A solution of urea-melt treated single-walled carbon nanotubes in water (nanotube concentration ~1.3 g/L) was diluted with water to 50% concentration, and then 10 µL of the diluted solution was applied and then spun at 3000 rpm for 60 seconds to produce a transparent film of carbon nanotubes on the substrate. Similarly, films were prepared with nanotube solutions that were diluted to 33% concentration and 25% concentration. Scanning electron microscopy (SEM) images of the films so obtained are shown in FIGURE 12.

### EXAMPLE 7

### Estimation of the sheet resistance of a film of single walled carbon nanotubes prepared by one spin-coating onto glass/PMMA/PVOH

Onto a clean 25 mm x 25 mm piece of glass was placed 100 µL of a solution of poly(methyl methacrylate) (PMMA, molecular weight ca 996000, from Sigma-Aldrich Co.) in toluene with a concentration of 4 mg per gram (4%) and then the sample was spun at 3000 rpm for 60 seconds to produce a transparent ~100-nm thick PMMA film on the substrate. Onto the PMMA film was placed 200 µL of a solution of PVOH (molecular weight 13000-23000, 98% hydrolyzed, from Sigma-Aldrich Co.) in water with a concentration of 4 mg per mL (4%). After 20-30 seconds, the sample was spun at 3000 rpm for 60 seconds to produce a transparent film of PVOH on the PMMA film. The bi-layered film was rinsed with several milliliters of water to dissolve the non-adsorbed PVOH and dried. A solution of urea-melt treated single walled carbon nanotubes in water (25 µL, nanotube concentration ~1.3 g/L) was applied and then spun at 3000 rpm for 60 seconds to produce a transparent film of carbon nanotubes on the substrate. Four interdigitated metal electrodes were deposited onto the film for electrical characterization. The electrodes were deposited by evaporation of the metal through a shadow mask. First a 1.5-nm thick layer of palladium and then a 50-nm thick layer of gold were deposited while the substrate was kept at a temperature close to room temperature. The widths of the electrodes and the gaps between them were 0.5 mm, and the channel length was 1.5 mm. Two tungsten probes were used to address the electrodes and the current (*I*) was measured as the applied voltage (*V*) was swept from -1 volt to +1 volt and back to -1 volt. Six *I-V* measurements were made with each sample, with the probes contacting the three pairs of adjacent electrodes, the two pairs of electrodes separated by one electrode, and the one pair of electrodes separated by two electrodes. Ohmic behavior was observed in each case, such as is shown by the example in FIGURE 13. The resistances obtained from the slopes had a linear dependence on the number of gaps between the electrodes and the intercept was relatively small, as is shown in the example in FIGURE 14, indicating that the contact resistance between the electrodes and the nanotube films was negligible. The sheet resistance (*R*ₛ) values estimated from this result and results from other samples are summarized in TABLE 3, together with the optical absorbance (*A*) and percent transmittance (%*T* = 10*^{-A}* x 100%) at 550 nm. The results generally show the steep reciprocal relationship between *A* and *R*ₛ that is expected for networks of nanotubes close to the percolation threshold.

**TABLE 3: Optical absorbance and transmittance at 550 nm and sheet resistance of single-walled carbon nanotube films that were spin-coated onto films of poly(methyl methacrylate) previously surface-modified by adsorption of polyvinyl alcohol**

| **Absorbance** | **%Transmittance** | **R_{S} (MΩ per sq)** |
|---|---|---|
| 0.0081 | 98 | 1.3 |
| 0.0121 | 97 | 0.57 |
| 0.0125 | 97 | 0.27 |
| 0.0126 | 97 | 0.53 |
| 0.0163 | 96 | 0.31 |
| 0.0221 | 95 | 0.67 |
| 0.0405 | 91 | 0.017 |

### EXAMPLE 8

### Spin-coating of deoxycholate-solubilized double-walled carbon nanotubes onto a polymer film surface-modified by adsorption with polyvinyl alcohol

Onto a clean 6 mm x 6 mm piece of silicon with a native oxide layer was placed 20 µL of a solution of poly(methyl methacrylate) (PMMA, molecular weight ca 996000, from Sigma-Aldrich Co.) in toluene with a concentration of 3 mg per gram (3%) and then the sample was spun at 3000 rpm for 90 seconds to produce a transparent ~50-nm thick PMMA film on the substrate. Onto the PMMA film was placed 30 µL of a solution of PVOH (molecular weight 13000-23000, 98% hydrolyzed, from Sigma-Aldrich Co.) in water with a concentration of 4 mg per mL (4%). After 60 seconds, the sample was spun at 3000 rpm for 90 seconds to produce a transparent film of PVOH on the PMMA film. The substrate was immersed in a bath of water (~5 mL) for 1 minute to dissolve the non-adsorbed PVOH and dried. A solution of double-walled carbon nanotubes (20 µL, nanotube concentration ~0.06 g/L) in sodium deoxycholate (NaDOC, 1 percent by weight in water) was applied and then spun at 3000 rpm for 90 seconds to produce a transparent film of carbon nanotubes embedded in excess NaDOC on the substrate. Water (30 µL) was applied to the substrate while it was being spun at 3000 rpm for 90 seconds to remove the excess surfactant. The latter two steps, *i*.*e*. spin-coating of nanotubes in NaDOC followed by rinsing with water to remove excess NaDOC, were repeated two more times. Scanning electron microscopy (SEM) images of the film after these three coating-rinsing steps are shown in FIGURE 15.

The features of the present invention disclosed in the specification, the claims and/or in the accompanying drawings, may, both separately, and in any combination thereof, be material for realizing the invention in various forms thereof.

The features of the present invention disclosed in the specification, the claims and/or in the accompanying drawings, may, both separately, and in any combination thereof, be material for realizing the invention in various forms thereof.

## Claims

1. A method of producing a film of carbon nanotubes on a substrate, comprising the steps:
a) providing a substrate having a surface,
b) treating said surface with a polyhydric compound, to yield a treated surface having hydrogen-bond forming groups,
c) providing a solution or suspension of carbon nanotubes and applying a layer of such solution or suspension on said treated surface, drying said layer or allowing said layer to dry, said layer thereby forming a film of carbon nanotubes on said surface of said substrate.

2. The method according to claim 1, wherein said treated surface has a static contact angle of water in the range of from 0 degrees to 90 degrees, preferably from 10 degrees to 90 degrees, more preferably from 30 degrees to 90 degrees and even more preferably from 50 degrees to 90 degrees.

3. The method according to any of claims 1 and 2, wherein said hydrogen-bond forming groups of said polyhydric compound are OH-groups, preferably hydroxyl groups of organic alcohols.

4. The method according to any of claims 1 - 2, wherein said polyhydric compound comprises a polyhydric polymer.

5. The method according to claim 4, wherein said polyhydric polymer is a polymer comprising polyvinyl alcohol.

6. The method according to any of claims 4 - 5, wherein said polyhydric polymer is polyvinyl alcohol.

7. The method according to any of claims 5 - 6, wherein said polyvinyl alcohol has the formula [-CH₂CHOH-] ₙ, wherein n is selected from the range 50 to 5000.

8. The method according to any of claims 5-6, wherein said polyvinyl alcohol has the formula [-CH₂CHOR-] ₙ, wherein n is selected from the range 50 to 5000, and wherein R is either H or -COCH₃ (acetyl) and the percentage of R that is H is selected from the range of 50% to 100%.

9. The method according to any of claims 5 - 8, wherein said polyvinyl alcohol has a molecular weight in the range of from 4000 - 200 000, preferably 4000 - 40 000, more preferably 11 000 - 24 000.

10. The method according to any of the foregoing claims, wherein step b) occurs by applying a solution, preferably an aqueous solution, of said polyhydric compound onto said surface.

11. The method according to claim 10, wherein said applying occurs by a technique selected from spin coating, dipping, drop casting, spraying. , and printing, including ink-jet printing and microcontact printing.

12. The method according to any of the foregoing claims, wherein, prior to step b), said substrate having a surface is a substrate having a static contact angle of water in the range of from 60 degrees to 120 degrees, preferably from 65 degrees to 105 degrees.

13. The method according to any of the foregoing claims, wherein said substrate is a polymeric substrate.

14. The method according to any of the foregoing claims, wherein said substrate comprises at least one polymer or polymer blend having carbonyl groups in the backbone or in a side group of said polymer or polymer blend.

15. The method according to any of the foregoing claims, wherein said substrate comprises at least one polymer or a polymer blend, said polymer and/or said polymer blend being selected from the group comprising polyesters of carboxylic acids, polyanhydrides of carboxylic acids, polycarbonates, and mixtures thereof.

16. The method according to any of the foregoing claims, wherein said substrate comprises at least one polymer selected from the group comprising poly(methyl methacrylate), polyethylene terephthalate, cellulose acetate and poly(oxycarbonyloxo-1,4-phenylene-isopropylidene-1,4-phenylene) (polycarbonate).

17. The method according to any of the foregoing claims, wherein said carbon nanotubes are dissolved or suspended in water with a concentration in the range of from 0.01 g/l to 10 g/l, or are dissolved or suspended in methanol or ethanol with a concentration in the range, of from 0.1 g/l to 1 g/l, to provide a solution or suspension of carbon nanotubes to be used in step c).

18. The method according to any of the foregoing claims, wherein said carbon nanotubes have hydrogen-bond forming groups on their surface(s), with said hydrogen-bond forming groups preferably being carbonyl groups.

19. The method according to any of the foregoing claims, wherein said carbon nanotubes have carboxyl (-COOH), amido (-NHCO-) and/or ureido (-NHCONH-) groups on their surface(s).

20. The method according to claim 19, wherein said carbon nanotubes have primary amido (-CONH₂) and/or primary ureido (-NHCONH₂) groups on their surface(s).

21. The method according to any of the foregoing claims, wherein said solution or suspension of carbon nanotubes is an aqueous solution or suspension of carbon nanotubes, or an alcoholic, preferably methanolic or ethanolic or a mixture thereof, solution or suspension of carbon nanotubes, or a mixture of an aqueous and alcoholic solution or suspension of carbon nanotubes.

22. The method according to any of the foregoing claims, wherein said carbon nanotubes, prior to dissolving or suspending them in an appropriate medium, such as an aqueous or alcoholic solvent, have been prepared by heating them in the presence of urea, optionally also in the presence of at least one aldehyde.

23. The method according to any of the foregoing claims, wherein said carbon nanotubes are single-walled, double-walled or multi-walled nanotubes or a mixture thereof.

24. The method according to any of the foregoing claims, wherein said applying a layer of a solution or suspension of carbon nanotubes in step c) on said treated surface occurs by a technique selected from spin coating, dipping, drop casting, spraying, and printing, including ink-jet printing or microcontact printing.

25. The method according to any of the foregoing claims, wherein said film of carbon nanotubes on said surface is a film having a coverage in the range of from submonolayer to multilayer.

26. The method according to any of the foregoing claims, wherein said film deposited in several layers.

27. A film of carbon nanotubes on a surface, prepared by the method according to any of the foregoing claims.

28. The film according to claim 27, wherein said film has a coverage in the range of from submonolayer to multilayer.

29. The film according to any of claims 27-28, which is a two-dimensional network of carbon nanotubes deposited on a substrate.

30. The film according to any of claims 27 - 29, which comprises an electrically conductive two-dimensional network of carbon nanotubes deposited on a substrate with an optical absorbance at 550 nm in the range of from 0.001 to 1 and with a sheet resistance in the range of from 10 Ω per square to 10 M Ω per square.

31. The film according to any of claims 27-29, which comprises an electrically non-conductive two dimensional network of carbon nanotubes deposited on a substrate with an optical absorbance at 550 nm of less than 0.01.

32. Use of a film according to any of claims 27-31 as or in an electrically conductive surface or electrode, or, as or in an electrically semiconductive surface.

33. Use according to claim 32, wherein said film is used for applications including energy applications such as solar cells, solid state lighting, electronics, such as passive and active matrix displays, thin film speakers, pick-up stick transistors, smart windows, appliances, such as touch screens, defrosting windows, and security applications, such as RFID tags, electromagnetic shielding and sensors.
